# EUROPEAN PATENT APPLICATION

(11) **EP 1 422 564 A1**
(43) Date of publication of application: **26.05.2004**
(21) Application number: 02450263.5
(22) Date of filing: 19.11.2002
(51) Int. Cl.: G03F 7/038, C08G 59/42

(54) **Photosensitive thermosetting resin and solder resist ink composition containing the same**

(71) Applicant: Great Eastern Resins Industrial Co., Ltd, Taichung (TW)
(72) Inventor: Tang, Frank, Taichung (TW)
(74) Representative: Cunow, Gerda

(57) **Abstract**

The present invention relates to a photosensitive thermosetting resin, which has more than two of ethylenically double bonds and carboxyl functional groups in one molecule thereof. The invention also relates to a solder resist ink composition, including (A) the above photosensitive thermosetting resin, (B) a photo-polymerization initiator, and (C) a thermo-hardener. The solder resist ink composition is suitably applied to a printed circuit board, and has excellent photosensitivity, solder resistance, electrical corrosion resistance, insulating properties and adhesion to copper foil.

## Description

### FIELD OF THE INVENTION

The present invention relates to a photosensitive thermosetting resin and a solder resist ink composition containing the same. The solder resist ink composition is suitably applied to a printed circuit board, and has excellent photosensitivity, solder resistance, electrical corrosion resistance, insulating properties and adhesion to copper foil.

### BACKGROUND OF THE INVENTION

Recently, conventional pure thermosetting solder resist ink applied to a screen priming process has been replaced with photosensitive thermosetting solder resist ink in accordance with increased circuitry of a printed circuit board (PCB). Normally, solder resist ink is required to have particular properties for use in PCB fabrication; for example, solder resist ink preferably have good heat resistance to sustain a high temperature as being dipped in solder during PCB fabrication, and needs to be excellent in adhesion to copper foil without causing delamination. Moreover, the solder resist ink also preferably has good electrical corrosion resistance and insulating properties. These properties are all required for application of the solder resist ink. Furthermore, in consideration of environmental protection and public safety, an organic solvent used in a developing process is gradually replaced by an alkali solution.

The foregoing requirements for properties of solder resist ink undesirably set limitation to application of solder resist ink materials; at present, only photosensitive resin synthesized from epoxy resin as a starting material may be considered adequate in concern of the property requirements. Such a photosensitive epoxy resin was described in U.S. Patent No. 4,146,452 (March. 1979) at the earliest or even earlier, but has been commercially applied to PCB fabrication only in this decade, for example in Taiwan Patent Publication Nos. 140202 and 257786.

However, the above photosensitive resin may still not have sufficient photosensitivity; therefore, it is usually added with water-soluble monomer containing ethylenically double bonds to improve its photosensitivity in use. The added amount of the water-soluble monomer has critical effect; properties of the photosensitive resin or solder resist ink may be degraded by excess addition of the monomer; on the other hand, photosensitivity may not be effectively improved if an insufficient amount of the monomer is added.

Therefore, the problem to be solved herein is to provide a solder resist ink composition that can eliminate the above defects or drawbacks.

### DETAILED DESCRIPTION OF THE INVENTION

The present invention relates to a photosensitive thermosetting resin, a solder resist ink composition containing the same, and a method for preparing the photosensitive thermosetting resin.

The solder resist ink composition according to the invention is suitably applied to a printed circuit board, and has excellent photosensitivity, solder resistance, electrical corrosion resistance, insulating properties and adhesion to copper foil.

The photosensitive thermosetting resin according to the invention is obtained by reacting phenolic epoxy resin having at least two epoxy functional groups in one molecule with unsaturated monocarboxylic acid, polyacid anhydride and unsaturated monomer having epoxy groups.

Accordingly, the method for preparing the photosensitive thermosetting resin according to the invention comprises the steps of:
(1) reacting phenolic epoxy resin having at least two epoxy groups in one molecule (a) with unsaturated monocarboxylic acid (b) at a temperature of 70 to 130°C, wherein a molar ratio of the unsaturated monocarboxylic acid to epoxy functional groups of the epoxy resin is 0.7 to 1.2, preferably 0.9 to 1.05, and more preferably 1;
(2) adding polyacid anhydride (c) to carry out the reaction at a temperature of 70 to 130°C when acid value of the reaction product of step (1) is decreased to 15mg KOH/g or less, wherein a molar ratio of the polyacid anhydride (c) to epoxy functional groups in the epoxy resin (a) of step (1) is 0.6 to 1.5, and preferably 0.8 to 1.3; and
(3) subsequently adding unsaturated monomer (d) having epoxy groups to react with the reaction product obtained from step (2) at a temperature of 60 to 100°C.

In the reaction, in order to control temperature and viscosity of the reactants, the reaction is usually carried out in the presence of an organic solvent. The suitable organic solvent includes carbitol acetate, petroleum naphthalene, petroleum ether, toluene, xylene, methyl ethyl acetone, ethyl acetate and butyl acetate, and the like; a solvent with a high flashing point such as a mixture of carbitol acetate and petroleum naphthalene is preferably used in concern of safety purpose for utilizing solder resist ink. And, the used amount of the organic solvent is not severely restricted as long as to facilitate performance of the reaction.

Furthermore, a catalyst may be added in the reaction of step (1) to promote the reaction rate. The catalyst includes trialkylamines such as triethylamine, and tetra-alkyl ammonium chloride such as methyltrimethylammonium chloride, triphenyl phosphine, and the like. The used amount of the catalyst is 1000 to 6000ppm with respect to the total amount of the reactants.

Moreover, in order to prevent gelation, a polymerization inhibitor such as hydroquinone, methyl hydroquinone and the like may be optionally added to the reaction. The added amount of the polymerization inhibitor is 200 to 2000ppm with respect to the total amount of the reactants.

In the reaction with polyacid anhydride of step (2), in order to control viscosity of the reactants, an organic solvent may be optionally added in an amount suitably facilitating performance of the reaction.

In the reaction with unsaturated monomer (d) having epoxy groups of step (3), the unsaturated monomer (d) having epoxy groups can react with carboxyl groups produced from step (2) to improve photosensitivity of the photosensitive resin (A), and also can be neutralized with the remaining polyacid in the reaction mixture to reduce damage from the remaining polyacid to properties of the solder resist ink. During storage or feeding of raw materials, water or moisture may easily get into the reactants and further react with polyacid anhydride to produce polyacid; when polyacid exists in the solder resist ink, adhesion of the solder resist ink to copper foil would be adversely affected.

Further, unsaturated monomer (d) can react with the remaining polyacid to form a reaction product having two ethylenically unsaturated bonds to be used as a good monomer for photopolymerization. Therefore, in the reaction of step (3), the reaction product produced from side reactions may effectively improve photosensitivity of the photosensitive resin and reduce adverse effect from polyacid to the solder resist ink.

Acid value of the photosensitive thermosetting resin according to the invention is preferably in the range of 60 to 160 mg KOH/g, and more preferably 80 to 140 mg KOH/g, If the acid value is too low, development of the solder resist ink composition would be adversely degraded; if the acid value is too high, adhesion of the solder resist ink to copper foil becomes worse and thus requires increased irradiation intensity.

Phenolic epoxy resin (a) used in the invention can be obtained by reacting epichlorohydrin or methyl epichlorohydrin with phenolic resin, which is prepared by reacting formaldehyde with phenol, cresol, halogenated phenol or alkyl phenol. In addition, the phenolic epoxy resin (a) used in the invention may also be commercial available, e.g. "NPCN-702" and "NPCN-704" from Nan-Ya Plastics Corporation, "CNE-202" and "CNE-204" from Chang-Chun Plastics Corporation, and "DEN-438" and "DEN-485" from Dow Chemical Corporation.

Examples of unsaturated monocarboxylic acid (b) used in the invention include acrylic acid, methacrylic acid, crotonic acid, cinnamic acid and the like, wherein acrylic acid is preferably used.

Examples of polyacid anhydride (c) used in the invention include succinic anhydride, maleic anhydride, phthalic anhydride and tetrahydrophthalic anhydride, wherein succinic anhydride and tetrahydrophthalic anhydride are preferably used.

Examples of unsaturated monomer (d) having epoxy groups used in the invention include (methyl)acrylate having epoxy groups such as glycidyl acrylate (GA), glycidyl methacrylate (GMA), (3,4-epoxy cyclohexyl) hexyl acrylate, (3,4-epoxy cyclohexyl) hexyl methacrylate, 3,4-epoxy indan-1-yl acrylate, 3,4-epoxy indan-1-yl methacrylate, 3,4-epoxy indan-1-yl oxyethyl acrylate, 3,4-epoxy indan-1-yl oxyethyl methacrylate and the like. And, glycidyl acrylaxe and glycidyl methacrylate are preferably used.

The present invention also relates to a solder resist ink composition comprising the photosensitive thermosetting resin obtained by the preparation method of the invention, a photopolymerization initiator and a thermo-hardener.

Examples of the photopolymerization initiator include benzoic acid, benzoic acid methyl ether, acetophenone and the like, which are commercial available, e.g. "Irgacure-907" and "ITX" from Ciba-Geigy Corporation. The used amount of the photopolymerization initiator is preferably 5 to 40 parts by weight, and more preferably 5 to 30 parts by weight with respect to 100 parts by weight of the photosensitive thermosetting resin.

The photosensitive resin must have carboxyl functional groups in its molecular structure to be developed by an alkaline aqueous solution. However, adhesion to copper foil and insulating properties of the photosensitive resin would be adversely affected by the presence of carboxyl functional groups; therefore, the thermo-hardener is added for neutralizing the carboxyl functional groups after development. As a result, the solder resist ink composition according to the invention needs to contain the thermo-hardener that has functional groups reactive with carboxylic acid and has excellent adhesion to copper foil and insulating properties. Such a thermo-hardener used in the solder resist ink composition according to the invention is preferably epoxy resin with good adhesion to copper foil and insulating properties, and epoxy groups of epoxy resin are reactive with carboxyl groups.

Epoxy resin used as the thermo-hardener in the composition according to the invention may be a conventional one and commercial available, e.g. "NPCN-702" and "NPCN-704" from Nan-Ya Plastics Corporation, "CNE-202" and "CNE-204" from Chang-Chun Plastics Corporation, "DEN-438" and "DEN-485" from Dow Chemical Corporation, "TEPIC" from Nissan Chemical Corporation, "YX-4000" and "YX-6056" from Yuka-Shell Corporation, and "Celloxide-2021" from Daicel Corporation. The added amount of the epoxy resin is 3 to 60 parts by weight, and preferably 5 to 50 parts by weight with respect to 100 parts by weight of the photosensitive thermosetting resin.

Further, the solder resist ink composition according to the invention may optionally contain a hardening promoter. Examples of the hardening promoter include ethyl guanamine, diamino diphenylmethane and melamine. The used amount of the hardening promoter is 1 to 5 parts by weight with respect to 100 parts by weight of the photosensitive thermosetting resin.

For increasing rigidity or hardness and adhesion to copper foil of the solder resist ink, an inorganic filler may be optionally added to the solder resist ink composition according to the invention. Examples of the inorganic filler include barium sulfate, carbon dioxide, talc powder, kaolin, calcium carbonate, and the like. The added amount of the inorganic filler is 5 to 100 parts by weight with respect to 100 parts by weight of the photosensitive thermosetting resin.

An adjuvant such as pigment, leveling agent, defoaming agent and the like may be optionally added to the solder resist ink composition according to the invention. For example, conventionally used pigments include phthalocyanine green, phthalocyanine blue, iodine green diazo yellow, and the like. The added amount of the adjuvant is 0.5 to 3 parts by weight with respect to 100 parts by weight of the photosensitive thermosetting resin.

### EXAMPLES

The present invention will be described in more detail by the following examples and experiment examples, which should not be construed as limitation to the scope embraced by the invention.

### Example 1

### (a) Synthesis of unsaturated resin (according to step (1) of the preparation method of the invention)

2050 parts by weight (10 equivalents) of toluene phenolic epoxy resin ("NPCN-704" from Nan-Ya Plastics Corporation; softening point: 85 to 95°C, Epoxy Equivalents: 205), 720 parts by weight (1.0 moles) of acrylic acid, 649 parts by weight of carbitol acetate, 278 parts by weight of naphthalene (as solvent), 11.1 parts by weight (3000ppm) of triphenylphosphine and 1.9 parts by weight (500ppm) of hydroquinone were charged into a reaction vessel and heated up to 100°C under stirring, allowing the reactants to react at 100°C for 12 hours and then to be cooled down to give unsaturated resin having acid value of less than 15mg KOH/g.

### (b) Synthesis of unsaturated polycarboxylic acid resin (according to step (2) of the preparation method of the invention)

1860 parts by weight (5 equivalents) ofthe unsaturated resin obtained from step (a) was charged into a reaction vessel, to which 760.8 parts by weight (5 moles) of tetrahydrophthalic anhydride, 576 parts by weight of carbitol acetate and 116 parts by weight of naphthalene (as solvent) were added, and then heated up to 95°C under stirring, allowing the reactants to react at 95°C for 8 hours and then to be cooled down to give unsaturated polycarboxylic acid resin having acid value of about 100mg KOH/g.

### (c) Synthesis of photosensitive thermosetting resin (according to step (3) of the preparation method of the invention)

70 parts by weight (0.107 equivalents) of the unsaturated polycarboxylic acid resin product obtained from step (b) was charged into a reaction vessel, to which 7.5 parts by weight of glycidyl methacrylate (GMA) and 4.0 parts by weight of carbitol acetate are added, allowing the reactants to react at 80°C for 8 hours and then to be cooled down to give the photosensitive thermosetting resin according to the invention with solid content of about 65%.

### Examples 2 to 9

The same procedures as in Example 1 were conducted except for different amounts of glycidyl methacrylate (GMA) being used as shown in Table 1. to thereby obtain the photosensitive thermosetting resin according to the invention with acid value determined in Table 1.

**Table 1**

| Example | 1 | 2 | 3 | 4 | 5 | 6 | 7 | 8 | 9 |
|---|---|---|---|---|---|---|---|---|---|
| Reaction product (parts by weight) of step (b) in Example 1 | 70.0 | 70.0 | 70.0 | 70.0 | 70.0 | 70.0 | 70.0 | 70.0 | 70.0 |
| Glycidyl methacrylate (parts by weight) | 7.5 | 6.3 | 5.9 | 5.4 | 4.9 | 4.3 | 3.8 | 3.4 | 2.9 |
| Carbitol acetate (parts by weight) | 4.0 | 3.4 | 3.2 | 2.9 | 2.6 | 2.3 | 2.1 | 1.8 | 1.5 |
| Acid value (mg KOH/g) | 80 | 85 | 90 | 95 | 100 | 105 | 110 | 115 | 120 |

### Comparative Examples 1 to 9

The same procedures as in Example 1 were conducted except that no glycidyl methacrylate (GMA) is added in step (c), and different amounts of tetrahydrophthalic anhydride are used in step (b) as shown in Table 2, so as to obtain the thermosetting resin free of GMA and having acid value determined in Table 2.

**Table 2**

| Example | 1 | 2 | 3 | 4 | 5 | 6 | 7 | 8 | 9 |
|---|---|---|---|---|---|---|---|---|---|
| Reaction product (parts by weight) of step (b) in Example 1 | 60.0 | 60.0 | 60.0 | 60.0 | 60.0 | 60.0 | 60.0 | 60.0 | 60.0 |
| Tetrahydrophthalic anhydride (parts by weight) | 9.7 | 10.7 | 11.7 | 12.7 | 13.7 | 14.7 | 15.7 | 16.7 | 17.7 |
| Carbitol acetate (parts by weight) | 4.2 | 4.5 | 4.8 | 5.0 | 5.3 | 5.6 | 5.9 | 6.2 | 6.5 |
| Petroleum naphthalene (as solvent) (parts by weight) | 10.2 | 10.5 | 10.8 | 11.0 | 11.3 | 11.6 | 11.9 | 12.2 | 12.5 |
| Acid value (mg KOH/g) | 80 | 85 | 90 | 95 | 100 | 105 | 110 | 115 | 120 |

### Formulation Examples 1 to 9 and Comparative Formulation Examples 1 to 9

Thermosetting resins obtained from Examples 1 to 9 and from Comparative Examples 1 to 9 was used as photosensitive resins, and mixed and stirred according to the following formulae to be fully pulverized to form solder resist ink compositions of Formulation Examples 1 to 9 and Comparative Formulation Examples 1 to 9.

| Composition | Parts by weight |
|---|---|
| Photosensitive resin | 153.8 |
| Barium sulfate B-30 ¹ | 50.0 |
| Epoxy resin ² | 20.0 |
| Photopolymerization initiator ³ | 12.0 |
| Quantacure ITX ⁴ | 1.0 |
| Lionol Green 2Y-301 ⁵ | 1.0 |

| | |
|---|---|
| (*1): from Kai Chemicals Incorporation, Japan, inorganic filler with particle diameter: 0.3µm. | |
| (*2): triglycidyl isocyanate from Nissan Chemical Industrial Corporation, Japan, trade name: TEPIC. | |
| (*3): 2-methyl-1-[4-(methylthio)phenyl]-2-morpholino-propanon-1 from Ciba-Geigy Corporation, trade name: Irgacure-907. | |
| (*4): 2-isopropyl thienone/4-isopropyl thienone (80/20) from Great Lakes Chemical. | |
| (*5): phthalocyanine (C.I. pigment green 36) from Toyo Ink Incorporation. | |

### Experiment Example

Each of the solder resist ink compositions of Formulation Examples 1 to 9 and Comparative Formulation Examples 1 to 9 was applied over a copper-coated substrate, dried at 76°C for 1 hour, and exposed by using a mercury ultraviolet light lamp with a wavelength of 300 to 340 cm⁻¹ and light intensity of 475 mJ/cm². Stouffer 21-Step Sensitivity Guide and Stouffer 1-T Resolution Guide were used as exposure negatives; development was carried out by using 1% sodium carbonate aqueous solution, and then washed for 60 seconds at 1.8 kg/cm² of water pressure. Photosensitivity was evaluated according to Stouffer 21-Step Sensitivity Guide readings; the higher the reading, the better the photosensitivity is. Results were shown in Tables 3 and 4.

Furthermore, in practical fabrication of a printed circuit board, after performing coating and drying processes, solder resist ink may need to be temporarily stored prior to exposure and development. If the storage period is too long, performance of development would be adversely affected and leads to so-called "heat fogging" effect. Accordingly, after each of the solder resist ink compositions of Formulation Examples 1 to 9 and Comparative Formulation Examples 1. to 9 was applied over the copper-coated substrate and dried at 76°C for 1 hour, it is stored for 24 hours and then subject to exposing and developing processes to observe whether adverse effect or heat-fogging effect is induced during development. Results were shown in Tables 3 and 4.

**Table 3**

| Formulation Example | 1 | 2 | 3 | 4 | 5 | 6 | 7 | 8 | 9 |
|---|---|---|---|---|---|---|---|---|---|
| Photosensitivity of the solder resist ink | 10 | 10 | 9 | 8 | 8 | 7 | 6 | 6 | 6 |
| heat fogging | X | X | X | X | V | V | V | V | V |

**Table 4**

| Comparative Formulation Example | 1 | 2 | 3 | 4 | 5 | 6 | 7 | 8 | 9 |
|---|---|---|---|---|---|---|---|---|---|
| Photosensitivity of the solder resist ink | #N/A | 5 | 4 | 4 | 4 | 4 | 3 | 2 | 2 |
| heat fogging | X | V | V | V | V | V | V | V | V |

By comparing the results shown in Tables 3 and 4, the solder resist ink compositions manufactured from the photosensitive thermosetting resin according to the invention have excellent pbotosensitivity and storage stability.

## Claims

1. A photosensitive thermosetting resin, comprising a plurality of ethylenically unsaturated double bonds and carboxyl groups in one molecule thereof, and obtained by reaction of phenolic epoxy resin having a plurality of epoxy functional groups with unsaturated monocarboxylic acid, polyacid anhydride and unsaturated monomer having epoxy groups.

2. The photosensitive thermosetting resin according to claim 1, wherein the unsaturated monocarboxylic acid is selected from the group consisting of acrylic acid, methacrylic acid, crotonic acid and cinnamic acid.

3. The photosensitive thermosetting resin according to claim 1 or 2, wherein the polyacid anhydride is selected from the group consisting of succinic anhydride, maleic anhydride, phthalic anhydride and tetrahydrophthalic anhydride.

4. The photosensitive thermosetting resin according to claim 1, 2 or 3, wherein the unsaturated monomer having epoxy groups is selected from the group consisting of glycidyl acrylate, glycidyl methacrylate, (3,4-epoxy cyclohexyl) hexyl acrylate, (3,4-epoxy cyclohexyl) hexyl methacrylate, 3,4-epoxy indan-1-yl acrylate, 3,4-epoxy indan-1-yl methacrylate, 3,4-epoxy indan-1-yl oxyethyl acrylate, and 3,4-epoxy indan-1-yl oxyethyl methacrylate.

5. A method for preparing a photosensitive thermosetting resin, comprising the steps of:
(1) reacting a phenolic epoxy resin (a) having at least two epoxy functional groups in one molecule thereof with unsaturated monocarboxylic acid (b) at a temperature of 70 to 130°C, wherein a molar ratio of the unsaturated monocarboxylic acid (b) to the epoxy functional groups of the epoxy resin (a) is 0.7 to 1.2;
(2) adding polyacid anhydride (c) to perform reaction at a temperature of 70 to 130°C when acid value of a reaction product of the step (1) is decreased to 15mg KOH/g or less, wherein a molar ratio of the polyacid anhydride (c) to the epoxy functional groups of the epoxy resin (a) of the step (1) is 0.6 to 1.5; and
(3) adding unsaturated monomer (d) having epoxy groups to react with a product obtained from the step (2) at a temperature of 60 to 100°C.

6. The method according to claim 5, wherein the unsaturated monocarboxylic acid is selected from the group consisting of acrylic acid, methacrylic acid, crotonic acid and cinnamic acid.

7. The method according to claim 5 or 6, wherein the polyacid anhydride is selected from the group consisting of succinic anhydride, maleic anhydride, phthalic anhydride and tetrahydrophthalic anhydride.

8. The method according to claim 5, 6 or 7, wherein the unsaturated monomer having epoxy groups is selected from the group consisting of glycidyl acrylate, glycidyl methacrylate, (3,4-epoxy cyclohexyl) hexyl acrylate, (3,4-epoxy cyclohexyl) hexyl methacrylate, 3,4-epoxy indan-1-yl acrylate, 3,4-epoxy indan-1-yl methacrylate, 3,4-epoxy indan-1-yl oxyethyl acrylate, and 3,4-epoxy indan-1-yl oxyethyl methacrylate.

9. A solder resist ink composition, comprising 100 parts by weight of the photosensitive thermosetting resin according to any one of claims 1 to 4, 5 to 40 parts by weight of a photopolymerization initiator, and 3 to 60 parts by weight of a thermo-hardener.

10. The solder resist ink composition according to claim 9, wherein the thermo-hardener is epoxy resin.

11. The solder resist ink composition according to claim 9 or 10, further comprising a hardening promoter selected from the group consisting of ethyl guanamine, diamino diphenylmethane and melamine.
